# EUROPÄISCHE PATENTANMELDUNG

(11) **EP 4 057 412 A1**
(43) Veröffentlichungstag der Anmeldung: **14.09.2022**
(21) Anmeldenummer: 22158966.6
(22) Anmeldetag: 25.02.2022
(51) Int. Cl.: H01M 10/0525, B60L 50/64, B60L 58/26, H01M 10/42, H01M 10/655, H01M 10/6556, H01M 50/20, H01M 50/287

(54) **BATTERIEMODULELEMENT, VERFAHREN ZUR HERSTELLUNG EINES SOLCHEN UND BATTERIEMODUL**

(30) Priorität: 09.03.2021 DE 102021202286
(71) Anmelder: Robert Bosch GmbH, 70442 Stuttgart (DE)
(72) Erfinder: Schmitt, Markus, 71732 Tamm (DE); Kohler, Robert, 70435 Stuttgart (DE); Kopp, Benjamin, 71686 Remseck Am Neckar (DE); Marx, Roman, 71297 Moensheim (DE)

(57) **Zusammenfassung**

Die Erfindung betrifft ein Batteriemodulelement mit einem Gehäuseelement (2) eines Batteriemoduls, an welchem an einer ersten Seite (21) eine elektrische Leiterplatte (3) angeordnet ist, wobei eine Induktivität (6) an der elektrischen Leiterplatte (3) derart mechanisch angeordnet ist, dass zumindest ein Ende (71) einer Spulenwicklung (7) der Induktivität (6) durch die elektrische Leiterplatte (3) hindurch verlaufend angeordnet ist und thermisch leitend mit dem Gehäuseelement (2) verbunden ist, und wobei das Gehäuseelement (2) an einer der ersten Seite (21) gegenüberliegenden zweiten Seite (22) eine von Temperierfluid umströmbar ausgebildete Temperierstruktur (5) umfasst, sodass eine Wärme von der Spulenwicklung (7) auf das Temperierfluid übertragbar ist.

## Beschreibung

### Stand der Technik

Die Erfindung geht aus von einem Batteriemodulelement nach Gattung des unabhängigen Anspruchs. Ferner betrifft die Erfindung auch die Herstellung eines solchen und ein Batteriemodul.

Aus dem Stand der Technik ist es bekannt, dass ein Batteriemodul eine Mehrzahl an einzelnen Batteriezellen aufweist, welche jeweils einen positiven Spannungsabgriff und einen negativen Spannungsabgriff aufweisen, wobei zu einer elektrisch leitenden seriellen und/oder parallelen Verbindung der Mehrzahl an Batteriezellen untereinander die jeweiligen Spannungsabgriffe elektrisch leitend miteinander verbunden sind und somit zu dem Batteriemodul zusammengeschaltet werden können. Batteriemodule ihrerseits werden zu Batterien bzw. zu gesamten Batteriesystemen zusammengeschaltet.

Aufgrund einer Vielzahl an möglichen, verschiedenen Fahrzeugbauräumen sind variable Modulgrößen anzustreben, um den vorhandenen Bauraum optimal ausnutzen zu können.

Weiterhin erwärmen sich die Batteriezellen eines Batteriemoduls, wie beispielsweise Lithium-Ionen-Batteriezellen oder Lithium-Polymer-Batteriezellen, während eines Betriebes bedingt durch chemische Wandlungsprozesse aufgrund ihres elektrischen Widerstandes bei einer Leistungsabgabe oder einer Leistungsaufnahme. Insbesondere bei einer vergleichbar schnellen Energieabgabe bzw. Energieaufnahme sind diese Prozesse vergleichbar ausgeprägt.

Je leistungsfähiger eine Batterie bzw. ein Batteriemodul ist, desto ausgeprägter ist auch die entstehende Erwärmung und damit einhergehend die Anforderungen an ein effizientes Temperiersystem. Um die Sicherheit eines Batteriemoduls zu erhöhen und auch die Leistungsfähigkeit der Batteriezellen sicherzustellen, sind die Batteriezellen eines Batteriemoduls sowohl zu heizen als auch zu kühlen, um diese möglichst in einem bestimmten Temperaturbereich betreiben zu können, sodass beispielsweise ein erhöhtes Alterungsverhalten bzw. eine Zersetzung der Zellchemie verhindert werden kann.

Überwiegend sind die Batteriezellen jedoch zu kühlen.

Beispielsweise kann eine Temperierung, also eine Heizung oder Entwärmung, der Batterie durch eine Flüssigkeitstemperierung mit einem Wasser/Glykol-Gemisch ausgebildet werden. Dabei wird dieses Gemisch durch unterhalb des Batteriemoduls angeordnete Kühlplatten geleitet. Die Kühlplatte kann dabei an eine entsprechende Komponente eines Kühlkreislaufes angeschlossen sein.

Zudem sind auch die weiteren bspw. elektronischen Komponenten eines Batteriemoduls bzw. einer Batterie zu temperieren.

Stand der Technik sind bspw. EP 2023473 und US 2019/0335608.

### Offenbarung der Erfindung

Ein Batteriemodulelement mit den Merkmalen des unabhängigen Anspruchs bietet den Vorteil, dass eine zuverlässige Temperierung insbesondere einer Induktivität ausgebildet werden kann.

Dazu wird erfindungsgemäß ein Batteriemodulelement zur Verfügung gestellt. Das Batteriemodulelement umfasst dabei ein Gehäuseelement des Batteriemoduls, an welchem an einer ersten Seite eine elektrische Leiterplatte angeordnet ist. Dabei ist eine Induktivität an der elektrischen Leiterplatte in der Art mechanisch angeordnet, dass zumindest ein Ende einer Spulenwicklung der Induktivität durch die elektrische Leiterplatte hindurch verlaufend angeordnet ist und weiterhin thermisch leitend mit dem Gehäuseelement verbunden ist. Dabei umfasst das Gehäuseelement an einer der ersten Seite gegenüberliegenden zweiten Seite eine von Temperierfluid umströmbar ausgebildete Temperierstruktur. Somit ist eine Wärme von der Spulenwicklung auf das Temperierfluid übertragbar.

Durch die in den abhängigen Ansprüchen aufgeführten Maßnahmen sind vorteilhafte Weiterbildungen und Verbesserungen der im unabhängigen Anspruch angegebenen Vorrichtung möglich.

Unter einer Induktivität wird an dieser Stelle ein passive elektrisches und/oder elektronisches Bauelement mit einem festem oder einstellbarem Induktivitätswert verstanden.

Das Gehäuseelement ist insbesondere aus einem metallischen Werkstoff ausgebildet. Weiterhin kann das Gehäuseelement aus einem Werkstoff mit einer vergleichbar hohen thermischen Leitfähigkeit ausgebildet sein.

Unter einer mechanischen Anordnung sei an dieser Stelle verstanden, dass das zumindest eine Ende der Spulenwicklung der Induktivität die elektrische Leiterplatte hindurch verlaufend angeordnet ist und beispielsweise zudem in diese eingepresst sein kann.

Es ist besonders zweckmäßig, wenn das zumindest eine Ende der Spulenwicklung der Induktivität unmittelbar benachbart zu der Temperierstruktur angeordnet ist, insbesondere ist das zumindest eine Ende oberhalb der Temperierstruktur angeordnet. Darunter soll verstanden sein, dass eine möglichst kurze Wegstrecke zwischen dem zumindest einen Ende der Spulenwicklung der Induktivität und der Temperierstruktur ausgebildet ist. Insbesondere kann die unmittelbar benachbart zu der Induktivität angeordnete Temperierstruktur zu einer Wärmeabfuhr optimiert werden.

Besonders bevorzugt sind zwei Enden der Spulenwicklung der Induktivität an der Leiterplatte angeordnet. Insbesondere sind die zwei Enden der Spulenwicklung mechanisch und elektrisch an der Leiterplatte angeordnet. Unter einer elektrischen Anordnung sei an dieser Stelle verstanden, dass das Ende der Spulenwicklung der Induktivität elektrisch leitend mit der elektrischen Leiterplatte verbunden ist.

Es ist besonders zweckmäßig, wenn das zumindest eine Ende der Spulenwicklung der Induktivität in einer Vertiefung des Gehäuseelements aufgenommen ist. Besonders bevorzugt ist diese Aufnahme thermisch leitend ausgebildet. Dadurch ist eine besonders zuverlässige Wärmeübertragung von dem zumindest ein Ende der Spulenwicklung der Induktivität auf das Gehäuseelement möglich. Insbesondere kann hierdurch die wärmeübertragende Fläche vergrößert werden und auch eine zuverlässige Befestigung ausgebildet werden.

Vorteilhaft ist es auch, wenn die elektrische Leiterplatte zumindest eine Öffnung aufweist, welche insbesondere die elektrische Leiterplatte hindurch verlaufend ausgebildet ist. Dabei ist ein Vorsprung des Gehäuseelements in der zumindest einen Öffnung aufgenommen. Besonders bevorzugt ist diese Aufnahme thermisch leitend ausgebildet. Dadurch ist es möglich, die elektrische Leiterplatte thermisch leitend an das Gehäuseelement anzubinden. Weiterhin kann bei einer die elektrische Leiterplatte hindurch verlaufenden Öffnung auch die Spulenwicklung, wie etwa ein mittlerer Bereich der Spulenwicklung, thermisch leitend an das Gehäuseelement angebunden werden. Dazu kann die zumindest eine Öffnung bspw. unterhalb der Induktivität angeordnet sein.

Gemäß einem bevorzugten Aspekt der Erfindung ist zwischen dem zumindest einen Ende der Spulenwicklung der Induktivität und dem Gehäuseelement, insbesondere der Vertiefung, ein thermisches Ausgleichsmaterial angeordnet. Gemäß einem weiteren bevorzugten Aspekt der Erfindung ist zwischen der elektrischen Leiterplatte und/oder der Spulenwicklung und dem Gehäuseelement, insbesondere dem Vorsprung, ein thermisches Ausgleichsmaterial angeordnet.

Hierzu kann das thermische Ausgleichsmaterial beispielsweise während der Herstellung in der Vertiefung des Gehäuseelements und/oder der Öffnung der elektrischen Leiterplatte angeordnet werden. Insbesondere kann ein Gap-Filler hierzu beispielsweise dispenst werden. Während der Herstellung taucht bei der Anordnung der elektrischen Leiterplatte an dem Gehäuseelement das zumindest eine Ende des Spulenelements in die Vertiefung ein und bildet hierbei einen zuverlässigen mechanischen und thermischen Kontakt aus. Insbesondere kann hierbei auch ein Teil des thermischen Ausgleichsmaterials verdrängt werden, welches durch einen Spalt zwischen der elektrischen Leiterplatte und der Vertiefung entweichen kann. Zudem taucht während der Herstellung der Vorsprung des Gehäuseelements in die Öffnung der elektrischen Leiterplatte ein und bildet hierbei einen zuverlässigen mechanischen und thermischen Kontakt aus. Insbesondere kann hierbei auch ein Teil des thermischen Ausgleichsmaterials verdrängt werden, welches durch ein Spalt zwischen der elektrischen Leiterplatte und dem Vorsprung entweichen kann.

Hierdurch können zum einen das zumindest eine Ende der Spulenwicklung der Induktivität und zum anderen auch die elektrische Leiterplatte thermisch leitend an dem Gehäuseelement angeordnet werden.

Ein thermisches Ausgleichsmaterial dient dazu, Unebenheiten oder nicht gewünschte Abstände zwischen einzelnen Elementen auszugleichen und hierdurch eine zuverlässige thermische Leitung auszubilden.

Es ist besonders zweckmäßig, wenn die Temperierstruktur zumindest ein Strömungsleitelement und/oder zumindest ein Strömungsstörelement umfasst. Strömungsleitelemente dienen hier insbesondere dazu, eine Temperierfluidströmung zu führen und umzulenken. Strömungsstörelemente dienen hier insbesondere dazu, eine Turbulenz einer Temperierfluidströmung zu erhöhen und insbesondere einen Übergang von einer laminaren zu einer turbulenten Strömung auszubilden. Strömungsleitelemente und/oder Strömungsstörelemente können hier entsprechend den thermischen Anforderungen einer Kühlung, wie beispielsweise der Induktivität, der elektrischen Leiterplatte oder auch weiterer elektrischer oder elektronischer Bauteile, angeordnet werden. Insbesondere können Strömungsstörelemente an vergleichbar intensiv zu kühlenden Stellen bzw. Bereichen des Gehäuseelements angeordnet werden. Die übrigen Bereiche können strömungs- und druckverlustoptimiert ausgebildet werden.

Besonders zweckmäßig ist, wenn ein Abdeckelement in der Art an dem Gehäuseelement angeordnet ist, dass ein von dem Temperierfluid durchströmbarer Temperierkanal ausgebildet ist. An dieser Stelle sei angemerkt, dass in dem Temperierkanal strömendes Temperierfluid insbesondere die Temperierstruktur umströmt bzw. an ihr entlang strömt.

Das Gehäuseelement kann ferner einen Einlass, welcher zu einem Einströmen des Temperierfluids in den Temperierkanal hinein ausgebildet ist, und einem Auslass, welcher zu einem Ausströmen des Temperierfluids aus dem Temperierkanal heraus ausgebildet ist. Besonders bevorzugt kann das Gehäuseelement in der Art ausgebildet sein, dass eine U-förmige Strömungsführung ausgebildet ist.

Zweckmäßigerweise ist das Gehäuseelement als Druckguss ausgebildet. Insbesondere sind hierbei auch die Vertiefung und/oder der Vorsprung in dem Druckguss ausgebildet. Zudem sind hierbei insbesondere auch die Temperierstruktur, wie beispielsweise das zumindest eine Strömungsleitelement und das zumindest eine Strömungsstörelement in dem Druckguss ausgebildet.

Ein besonderer Vorteil der Erfindung ist, dass die Induktivität thermisch leitend an die Temperierstruktur des Gehäuseelements angebunden werden kann.

Weiterhin betrifft die Erfindung auch ein Batteriemodul mit einem erfindungsgemäßen Batteriemodulelement.

Ferner betrifft die Erfindung auch ein Verfahren zur Herstellung eines erfindungsgemäßen Batteriemodulelements. Dabei wird an einem Gehäuseelement eines Batteriemoduls an einer ersten Seite eine elektrische Leiterplatte angeordnet, wobei eine Induktivität an der elektrischen Leiterplatte derart mechanisch angeordnet wird, dass zumindest ein Ende einer Spulenwicklung der Induktivität durch die elektrische Leiterplatte hindurch verlaufend angeordnet wird und thermisch leitend mit dem Gehäuseelement verbunden wird. Dabei umfasst das Gehäuseelement an einer der ersten Seite gegenüberliegenden zweiten Seite eine von Temperierfluid umströmbar ausgebildete Temperierstruktur, sodass eine Wärme von der Spulenwicklung auf das Temperierfluid übertragbar ist.

Selbstverständlich kann das erfindungsgemäße Verfahren im Sinne des erfindungsgemäßen Batteriemodulelements weitergebildet werden.

### Kurze Beschreibung der Zeichnungen

Ausführungsbeispiele der Erfindung sind in den Zeichnungen dargestellt und in der nachfolgenden Beschreibung näher erläutert.

Es zeigt:
- Figur 1: einen Ausschnitt einer perspektivischen Ansicht auf eine erste Seite des Gehäuseelements,
- Figur 2: eine zweite Seite des Gehäuseelements,
- Figur 3: eine an einer Leiterplatte angeordnete der Induktivität und
- Figur 4: eine Schnittansicht eines erfindungsgemäßen Batteriemodulelements.

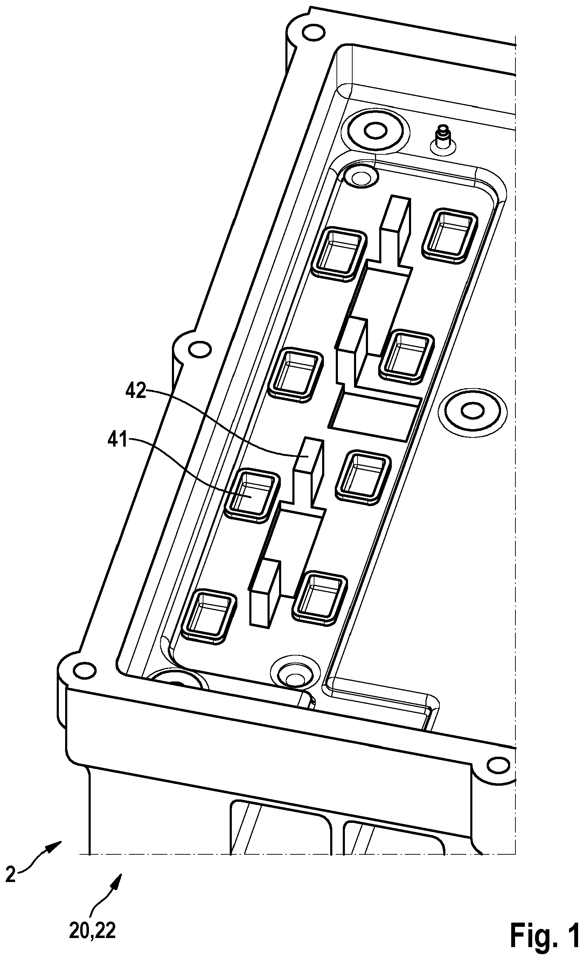

Die Figur 1 zeigt einen Ausschnitt einer perspektivischen Ansicht auf eine erste Seite 21 eines Gehäuseelements 2 eines Batteriemoduls. Das Gehäuseelement 2 des Batteriemoduls ist dabei als Druckguss 20 ausgebildet.

An der ersten Seite 21 kann eine in der Figur 1 nicht gezeigte elektrische Leiterplatte 3 angeordnet sein.

Aus der Figur 1 ist zu erkennen, dass beispielsweise an der ersten Seite 21 des Gehäuseelements 2 eine Vertiefung 41 des Gehäuseelements 2 ausgebildet sein kann.

Zudem ist aus der Figur 1 auch zu erkennen, dass beispielsweise an der ersten Seite 21 des Gehäuseelements 2 ein Vorsprung 42 des Gehäuseelements 2 ausgebildet sein kann.

Insbesondere sind die Vertiefung 41 und der Vorsprung 42 durch den Druckguss 20 ausgebildet.

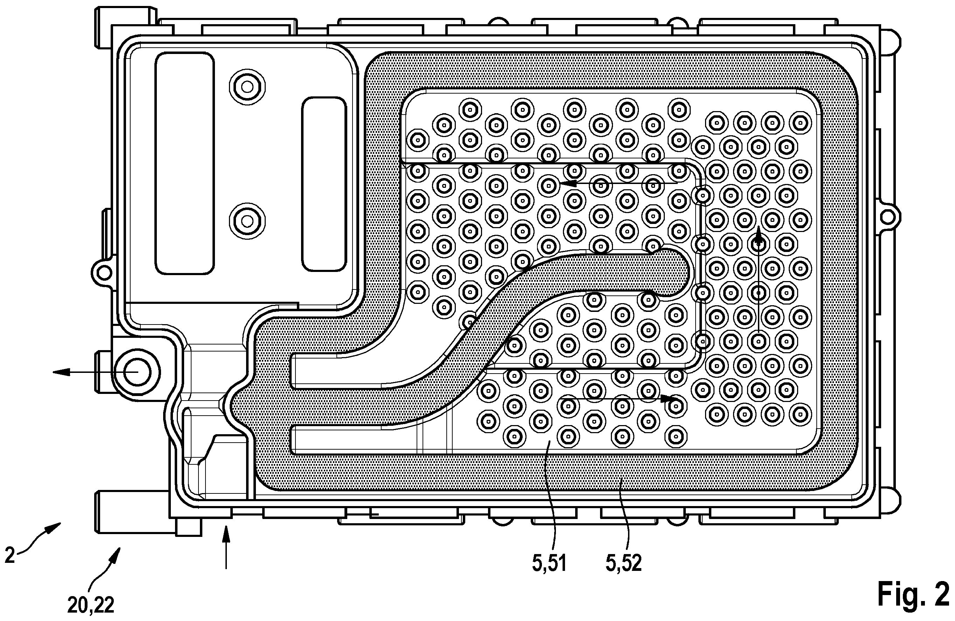

Die Figur 2 zeigt eine zweite Seite 22 des Gehäuseelements 2. Die zweite Seite 22 des Gehäuseelements 2 ist dabei der ersten Seite 21 des Gehäuseelements 2 gegenüberliegend angeordnet.

Das Gehäuseelement 2 umfasst dabei an der zweiten Seite 22 eine von Temperierfluid umströmbar ausgebildete Temperierstruktur 5. Die Temperierstruktur 5 umfasst dabei ein Strömungsleitelement 52 und eine Mehrzahl an Strömungsstörelementen 51.

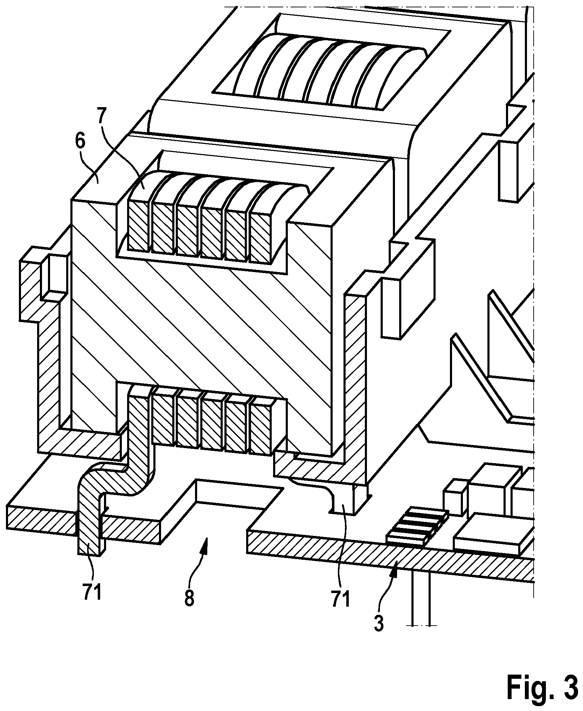

Die Figur 3 zeigt an einer Leiterplatte 3 angeordnete Induktivität 6. An dieser Stelle sei noch angemerkt, dass die Figur 3 eine Schnittansicht darstellt.

Die Induktivität 6 ist dabei mechanisch an der elektrischen Leiterplatte 3 angeordnet. Die Induktivität 6 umfasst dabei eine Spulenwicklung 7. Dabei sind Enden 71 der Spulenwicklung 7 der Induktivität 6 durch die elektrische Leiterplatte 3 hindurch verlaufend angeordnet. Insbesondere sind zwei Enden 71 der Spulenwicklung 7 der Induktivität 6 mechanisch und elektrisch an der Leiterplatte 3 angeordnet.

Die Enden 71 der Spulenwicklung 7 der Induktivität 6 können dabei in der in Figur 1 gezeigten Vertiefung 41 des Gehäuseelements 2 aufgenommen werden.

Weiterhin ist aus der Figur 3 auch zu erkennen, dass die elektrische Leiterplatte 3 eine Öffnung 8 aufweist. Die Öffnung 8 ist dabei die elektrische Leiterplatte 3 hindurch verlaufend ausgebildet.

Ein in der Figur 1 gezeigter Vorsprung 42 des Gehäuseelements 2 kann dabei in der Öffnung 8 des Gehäuseelements 2 aufgenommen werden.

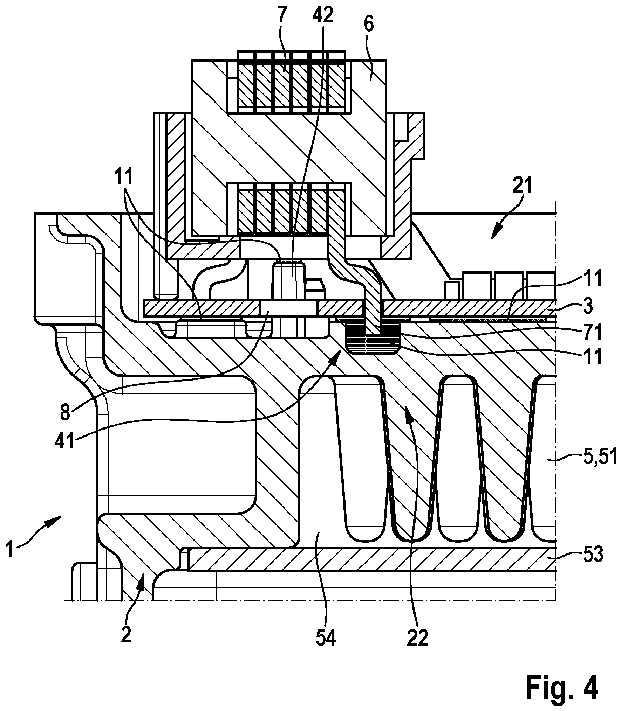

Die Figur 4 zeigt eine Schnittansicht eines erfindungsgemäßen Batteriemodulelements 1.

Dabei ist das Gehäuseelement 2 des Batteriemoduls zu erkennen, an welchem an der ersten Seite 21 die elektrische Leiterplatte 3 angeordnet ist. Dabei ist die Induktivität 6 an der elektrischen Leiterplatte 3 in der Art mechanisch angeordnet, dass die Enden 71 der Spulenwicklung 7 der Induktivität 6 durch die elektrische Leiterplatte 3 hindurch verlaufend angeordnet sind und thermisch leitend mit dem Gehäuseelement 2 verbunden sind.

Weiterhin ist zu erkennen, dass an der der ersten Seite 41 gegenüberliegend angeordneten zweiten Seite 22 die von Temperierfluid umströmbar ausgebildete Temperierstruktur 5 ausgebildet ist. Somit kann eine Wärme von der Spulenwicklung 7 auf das Temperierfluid übertragen werden.

Dabei ist ein Abdeckelement 53 in der Art an dem Gehäuseelement 2 angeordnet, dass ein von dem Temperierfluid durchströmbarer Temperierkanal 54 ausgebildet ist.

Das Ende 71 der Spulenwicklung 7 ist dabei unmittelbar benachbart zu der Temperierstruktur 5 und insbesondere auch zu dem Temperierkanal 54 angeordnet.

Weiterhin ist in der Figur 4 zu erkennen, dass das Ende 71 der Spulenwicklung 7 der Induktivität 6 in der Vertiefung 41 des Gehäuseelements 2 aufgenommen ist.

Ferner ist in der Figur 4 zu erkennen, dass der Vorsprung 42 des Gehäuseelements 2 in der Öffnung 8 der elektrischen Leiterplatte 3 aufgenommen ist.

Dabei ist zwischen den Enden 71 der Spulenwicklung 7 der Induktivität 6 und dem Gehäuseelement 2 bzw. insbesondere der Vertiefung 41 ein thermisches Ausgleichsmaterial 11 angeordnet. Weiterhin ist auch zwischen der Spulenwicklung 7 und dem Gehäuseelement 2 bzw. insbesondere dem Vorsprung 42 ein thermisches Ausgleichsmaterial 11 angeordnet. Weiterhin kann auch zwischen der elektrischen Leiterplatte 3 und dem Gehäuseelement 2 ein thermisches Ausgleichsmaterial 11 angeordnet sein.

Zudem sind in der Figur 4 Strömungsstörelemente 51 der Temperierstruktur 5 zu erkennen.

Wärme kann hierbei beispielsweise von der Spulenwicklung 7 auf den Vorsprung 42 übertragen werden, von dem Ende 71 der Spulenwicklung 7 auf die Vertiefung 41 übertragen werden und von der elektrischen Leiterplatte 3 auf das Gehäuseelement 2 übertragen werden. Insgesamt kann also zuverlässig Wärme von der Induktivität 6 und der elektrischen Leiterplatte 3 auf das Gehäuseelement 2 übertragen werden. Von dem Gehäuseelement 2 kann diese Wärme nun in Richtung der Temperierstruktur 5 geleitet werden. Die Temperierstruktur 5 überträgt die Wärme weiterhin auf das Temperierfluid. Somit können die Induktivität 6 und die elektrische Leiterplatte 3 zuverlässig Wärme auf das Temperierfluid übertragen, wodurch eine Wärmeabfuhr von der Induktivität 6 und der elektrischen Leiterplatte 3 ermöglicht ist.

## Patentansprüche

1. Batteriemodulelement mit
einem Gehäuseelement (2) eines Batteriemoduls, an welchem an einer ersten Seite (21) eine elektrische Leiterplatte (3) angeordnet ist, wobei
eine Induktivität (6) an der elektrischen Leiterplatte (3) derart mechanisch angeordnet ist, dass
zumindest ein Ende (71) einer Spulenwicklung (7) der Induktivität (6) durch die elektrische Leiterplatte (3) hindurch verlaufend angeordnet ist und thermisch leitend mit dem Gehäuseelement (2) verbunden ist, und wobei das Gehäuseelement (2) an einer der ersten Seite (21) gegenüberliegenden zweiten Seite (22) eine von Temperierfluid umströmbar ausgebildete Temperierstruktur (5) umfasst, sodass
eine Wärme von der Spulenwicklung (7) auf das Temperierfluid übertragbar ist.

2. Batteriemodulelement nach dem vorherigen Anspruch 1,
**dadurch gekennzeichnet, dass**
zwei Enden (71) der Spulenwicklung (7) der Induktivität (6), insbesondere mechanisch und elektrisch, an der Leiterplatte (3) angeordnet sind.

3. Batteriemodulelement nach einem der vorherigen Ansprüche 1 bis 2,
**dadurch gekennzeichnet, dass**
das zumindest eine Ende (71) der Spulenwicklung (7) der Induktivität (6) in einer Vertiefung (41) des Gehäuseelements (2) aufgenommen ist.

4. Batteriemodulelement nach einem der vorherigen Ansprüche 1 bis 3,
**dadurch gekennzeichnet, dass**
die elektrische Leiterplatte (3) zumindest eine Öffnung (8) aufweist, welche insbesondere die elektrische Leiterplatte (3) hindurch verlaufend ausgebildet, und ein Vorsprung (42) des Gehäuseelements (2) in der zumindest einen Öffnung (8) aufgenommen ist.

5. Batteriemodulelement nach einem der vorherigen Ansprüche 1 bis 4, **dadurch gekennzeichnet, dass**
zwischen dem zumindest einen Ende (71) der Spulenwicklung (7) der Induktivität (6) und dem Gehäuseelement (2), insbesondere der Vertiefung (41), und/oder
zwischen der elektrischen Leiterplatte (3) und/oder der Spulenwicklung (7) und
dem Gehäuseelement (2), insbesondere dem Vorsprung (42),
ein thermisches Ausgleichsmaterial (11) angeordnet ist.

6. Batteriemodulelement nach einem der vorherigen Ansprüche 1 bis 5,
**dadurch gekennzeichnet, dass**
die Temperierstruktur (5) zumindest ein Strömungsleitelement (52) und/oder zumindest ein Strömungsstörelement (51) umfasst.

7. Batteriemodulelement nach einem der vorherigen Ansprüche 1 bis 6,
**dadurch gekennzeichnet, dass**
ein Abdeckelement (53) in der Art an dem Gehäuseelement (2) angeordnet ist, dass ein von dem Temperierfluid durchströmbarer Temperierkanal (54) ausgebildet ist.

8. Batteriemodulelement nach einem der vorherigen Ansprüche 1 bis 7,
**dadurch gekennzeichnet, dass**
das Gehäuseelement (2) als Druckguss (20) ausgebildet ist.

9. Batteriemodul mit einem Batteriemodulelement (1) nach einem der Ansprüche 1 bis 8.

10. Verfahren zur Herstellung eines Batteriemodulelements (1) nach einem der Ansprüche 1 bis 8, wobei
an einem Gehäuseelement (2) eines Batteriemoduls an einer ersten Seite (21) eine elektrische Leiterplatte (3) angeordnet wird, wobei eine Induktivität (6) an der elektrische Leiterplatte (3) derart mechanisch angeordnet wird, dass
zumindest ein Ende (71) einer Spulenwicklung (7) der Induktivität (3) durch die elektrische Leiterplatte (3) hindurch verlaufend angeordnet wird und
thermisch leitend mit dem Gehäuseelement (2) verbunden wird, und wobei das Gehäuseelement (2) an einer der ersten Seite (21) gegenüberliegenden zweiten Seite (22) eine von Temperierfluid umströmbar ausgebildete Temperierstruktur (5) umfasst, sodass
eine Wärme von der Spulenwicklung (7) auf das Temperierfluid übertragbar ist.
